# FASCICULE DE BREVET EUROPEEN

(11) **EP 4 043 312 B1**
(45) Date de publication et mention de la délivrance du brevet: **29.11.2023**
(21) Numéro de dépôt: 22152610.6
(22) Date de dépôt: 21.01.2022
(51) Int. Cl.: B61B 12/06, G01R 31/08

(54) **SYSTEME DE LOCALISATION DE DEFAUT**
FEHLERLOKALISIERUNGSSYSTEM
FAULT LOCATING SYSTEM

(30) Priorité: 11.02.2021 FR 2101331
(43) Date de publication de la demande: 17.08.2022
(73) Titulaire: POMA, 38340 Voreppe (FR)
(72) Inventeur: MATHIEU, Christian, 38180 SEYSSINS (FR)
(74) Mandataire: Alatis

(56) Documents cités:
- EP-A1- 0 180 501
- DE-A1- 2 628 013
- FR-A1- 2 504 482

## Description

### DOMAINE TECHNIQUE DE L'INVENTION

L'invention concerne, de façon générale, le domaine technique des installations destinées au transport de personnes ou de biens par câble aérien, notamment pour des remontées mécaniques utilisées dans les stations de ski, telles que télécabines, télésièges et téléskis.

L'invention se rapporte plus spécifiquement à un système de localisation de défaut sur une ligne électrique de sécurité s'étendant le long d'une telle installation de transport par câble.

### ÉTAT DE LA TECHNIQUE ANTÉRIEURE

De manière connue, une installation de transport par câble comporte au moins une ligne électrique dite de sécurité sur laquelle sont branchés en série une pluralité de contacts électriques de défaut de câble qui sont répartis le long de l'installation de transport. Ces contacts de défaut sont situés par exemple au niveau des différents pylônes de l'installation et sont actionnés par des détecteurs mécaniques de défaut qui détectent, grâce par exemple à des barrettes de sécurité sectionnables, un incident de type déraillement du câble au niveau d'un pylône.

Dès qu'un des contacts de défaut est ouvert, signifiant par exemple un déraillement du câble, alors la continuité de la ligne de sécurité n'est plus établie ce qui permet ainsi d'arrêter rapidement l'installation de transport pour des raisons évidentes de sécurité.

Cependant, lors de l'apparition d'un tel défaut, il est primordial de pouvoir localiser au mieux ce défaut de façon à pouvoir y remédier au plus vite et donc minimiser l'arrêt de l'installation. Or, une installation de transport par câble aérien s'étend sur une grande distance avec un nombre important de pylônes dont l'accès peut être difficile et long, en particulier en montagne. D'où l'importance d'avoir un système aidant les opérateurs à localiser un défaut.

Il existe déjà des solutions pour aider à la localisation d'un défaut de câble. Par exemple le document EP0180501 décrit un dispositif dans lequel la localisation est faite par une mesure du temps nécessaire à un signal électrique pour parcourir la distance entre l'émetteur du signal électrique, situé par exemple dans une station de base ou groupe de sécurité, et le détecteur de défaut. Cependant, ce système peut devenir moins précis et moins fiable dans le temps notamment en raison de l'usure du dispositif.

Une autre solution connue du document FR2504482 consiste à relier chaque contact de défaut à une résistance en parallèle dont la valeur est prédéterminée et distincte en fonction de la position du contact de défaut au sein de l'installation. A l'ouverture d'un des contacts de défaut, la résistance globale de la ligne de sécurité varie en fonction de la valeur de la résistance de ce contact ouvert. En mesurant la variation de tension sur la ligne de sécurité, on peut en déduire la valeur de la résistance parallèle et ainsi identifier quel est le contact en défaut. Cependant, un tel système est lui aussi peu précis pour des installations étendues ayant de nombreux contacts de défaut. De plus, comme une valeur distincte de résistance est nécessaire en parallèle de chaque contact de défaut, la maintenance d'un tel système se trouve compliquée. Ce système n'est pas non plus fonctionnel si jamais deux défauts apparaissaient en même temps.

### EXPOSÉ DE L'INVENTION

C'est pourquoi l'invention vise à remédier à tout ou partie des inconvénients de l'état de la technique en proposant une solution simple et fiable pour localiser un défaut de câble dans une installation de transport.

Pour cela l'invention décrit un système de localisation de défaut dans une installation de transport par câble, le système de localisation comprenant un groupe de sécurité, un module d'extrémité et une ligne électrique de sécurité reliant le groupe de sécurité au module d'extrémité, la ligne de sécurité comprenant une pluralité de contacts de défaut de câble, du type normalement fermé, qui sont reliés en série le long de la ligne de sécurité et dont l'ouverture signale un défaut de câble de l'installation de transport. Le système de localisation est caractérisé en ce qu'il comporte une pluralité de modules de localisation répartis le long de l'installation de transport et comprenant chacun un premier contact test, du type normalement ouvert, permettant de court-circuiter la ligne de sécurité, et en ce que suite à une détection d'un défaut provenant d'un des contacts de défaut de câble, chaque module de localisation est apte à fermer de façon sélective son premier contact test de façon à pouvoir localiser ledit contact en défaut le long de la ligne de sécurité.

Selon une caractéristique, chaque module de localisation comprend également un second contact test, de type normalement fermé, raccordé en série le long de la ligne de sécurité. Suite à une détection d'un défaut de court-circuit sur la ligne de sécurité, chaque module de localisation est apte à ouvrir de façon sélective son second contact test de façon à pouvoir localiser ledit défaut de court-circuit le long de la ligne de sécurité.

Selon une autre caractéristique, le groupe de sécurité comprend des moyens de détection d'un défaut de câble et d'un défaut de court-circuit survenant sur la ligne de sécurité.

Selon une autre caractéristique, le groupe de sécurité comprend des moyens de communication avec les modules de localisation pour demander la fermeture du premier contact test des modules de localisation de sorte que, lors d'une détection d'un défaut de câble provenant d'un des contacts de défaut de câble, le groupe de sécurité effectue une séquence itérative en demandant à des modules de localisation de fermer temporairement l'un après l'autre le premier contact test, jusqu'à déterminer la localisation du défaut de câble entre deux modules de localisation consécutifs.

Selon une autre caractéristique, le groupe de sécurité comprend des moyens de communication avec les modules de localisation pour demander l'ouverture du second contact test des modules de localisation de sorte que, lors d'une détection d'un défaut de court-circuit survenant sur la ligne de sécurité, le groupe de sécurité effectue une séquence itérative en demandant à des modules de localisation d'ouvrir temporairement l'un après l'autre leur second contact test, jusqu'à déterminer la localisation du défaut de court-circuit entre deux modules de localisation consécutifs.

Selon une autre caractéristique, chaque module de localisation comprend des moyens de détection d'un défaut de câble et d'un défaut de court-circuit survenant sur la ligne de sécurité. Lors d'une détection d'un défaut de câble provenant d'un des contacts de défaut de câble, chaque module de localisation ferme son premier contact test pendant une durée prédéterminée qui est fonction du rang du module de localisation dans l'installation de transport. De même lors d'une détection d'un défaut de court-circuit sur la ligne de sécurité, chaque module de localisation ouvre son second contact test pendant une durée prédéterminée qui est fonction du rang du module de localisation dans l'installation de transport.

L'invention décrit également un procédé de localisation de défaut dans une installation de transport par câble à l'aide d'un tel système de localisation. Lors d'une détection d'un défaut de câble provenant d'un des contacts de défaut de câble, le groupe de sécurité effectue une séquence itérative en demandant à des modules de localisation de fermer temporairement l'un après l'autre leur premier contact test et en analysant les signaux circulant sur la ligne de sécurité, jusqu'à déterminer la localisation du défaut de câble entre deux modules de localisation consécutifs. Lors d'une détection d'un défaut de court-circuit survenant sur la ligne de sécurité, le groupe de sécurité effectue une séquence itérative en demandant à des modules de localisation d'ouvrir temporairement l'un après l'autre leur second contact test et en analysant les signaux circulant sur la ligne de sécurité, jusqu'à déterminer la localisation du défaut de court-circuit entre deux modules de localisation consécutifs. Selon une caractéristique, la séquence itérative est de type incrémental, décrémental ou dichotomique.

### BRÈVE DESCRIPTION DES FIGURES

D'autres caractéristiques et avantages de l'invention ressortiront à la lecture de la description qui suit, en référence aux figures annexées dans lesquelles :
[Fig. 1] : la figure 1 montre une vue schématique simplifiée d'un mode de réalisation d'une ligne de sécurité de l'art antérieur dans une installation de transport par câble,
[Fig. 2] : la figure 2 représente une vue schématique simplifiée d'une ligne de sécurité conforme à l'invention,
[Fig. 3] : la figure 3 montre un exemple de diagrammes de signaux de tension circulant sur la ligne de sécurité,
[Fig. 4] : les figures 4.1 à 4.4 représentent un exemple de séquence pour la localisation d'un défaut de câble survenant sur la ligne de sécurité,
[Fig. 5] : les figures 5.1 à 5.4 représentent un exemple de séquence pour la localisation d'un défaut de court-circuit survenant sur la ligne de sécurité.

### DESCRIPTION DÉTAILLÉE D'UN MODE DE RÉALISATION

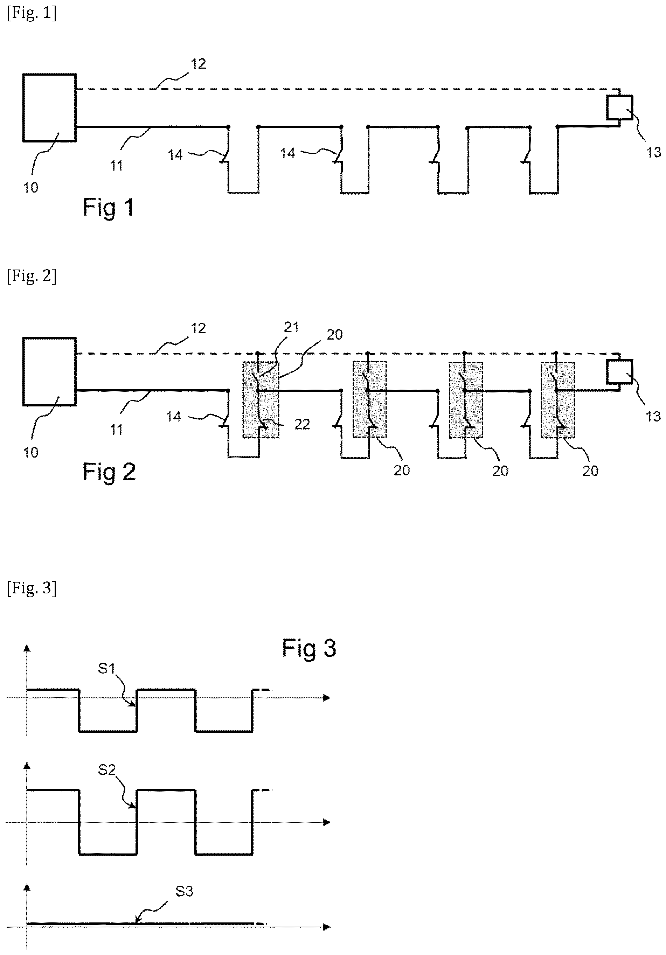

En référence à la figure 1, un système de détection de défaut du câble pour une installation de transport par câble comprend de façon connue un circuit électrique de sécurité raccordé entre d'un côté un groupe de sécurité 10 central et de l'autre côté un module d'extrémité 13. Le circuit de sécurité se compose d'une ligne de sécurité 11 principale et d'une ligne de retour 12. Le module d'extrémité 13 comporte par exemple une diode dont la cathode est reliée à la terre et le groupe de sécurité 10 est également relié à la terre, de sorte que la ligne de retour 12 du circuit de sécurité se fait en réalité par la terre.

Le groupe de sécurité 10 est un module de commande et de surveillance qui est généralement situé dans une gare motrice de l'installation de transport. Il comporte des moyens d'émission de signaux sur la ligne de sécurité 11 ainsi que des moyens de détection d'une ouverture de la ligne de sécurité 11 ou d'un court-circuit survenant sur la ligne de sécurité 11, en analysant les signaux circulant sur la ligne de sécurité 11. Préférentiellement, il comporte également des moyens de signalisation et de dialogue Homme-Machine, en particulier pour signaler la localisation d'un défaut aux opérateurs de l'installation de transport.

La ligne de sécurité 11 comporte une pluralité de contacts de défaut 14, qui sont représentatifs d'un défaut du câble de l'installation, tel qu'un déraillement. Ils sont du type normalement fermé et sont reliés en série le long de la ligne de sécurité 11. Dans le présent document, un contact est de type "normalement fermé" s'il est par défaut en position fermée (c'est-à-dire électriquement conducteur) en l'absence de commande. Inversement, un contact est de type "normalement ouvert" s'il est par défaut en position ouverte (c'est-à-dire électriquement non conducteur) en l'absence de commande. Ainsi, en fonctionnement normal, lorsque tous les contacts de défaut de câble 14 sont en position fermée, le circuit de sécurité formé par la ligne de sécurité 11 et la ligne de retour 12 est passant. En revanche, il suffit qu'un des contacts de défaut 14 passe en position ouverte pour que le circuit de sécurité 11 soit interrompu ce qui provoque un défaut de câble. Pour des raisons de simplification des dessins, l'exemple montré dans les figures comporte seulement quatre contacts de défaut 14 répartis le long de la ligne de sécurité 11.

Un contact de défaut 14 est par exemple directement composé d'une barrette sectionnable conductrice qui peut être placée, au niveau d'un pylône, à proximité d'un galet sur lequel passe le câble, et dont la rupture indique que le câble est sorti de son emplacement dans le galet. On pourrait aussi envisager des barrettes sectionnables mécaniques dont la rupture actionnerait un capteur de position faisant alors office de contact de défaut 14. De préférence, il existe plusieurs contacts de défaut 14 sur chaque pylône de l'installation.

En référence à la figure 2, le système de localisation selon l'invention comporte une pluralité de modules de localisation 20 qui sont répartis le long de l'installation de transport. Chaque module de localisation 20 comporte un contact 21 qui est du type normalement ouvert, et appelé premier contact test, ainsi que des moyens électroniques de commande de ce contact 21. Le premier contact test 21 est configuré pour que lorsque l'on commande sa fermeture, cela court-circuite la ligne de sécurité 11, par exemple en la raccordant à la terre.

Les modules de localisation 20 peuvent être placés par exemple au niveau de chaque pylône, mais suivant la configuration géographique de l'installation de transport et la précision souhaitée pour la localisation des défauts, on peut décider de placer plusieurs modules de localisation 20 par pylône, ou un module de localisation 20 pour plusieurs pylônes. Il est clair cependant que plus le nombre de modules de localisation 20 est important, plus la localisation d'un défaut de câble ou d'un défaut de court-circuit sera précise.

Pour des raisons de simplification des dessins, l'exemple montré dans les différentes figures comporte quatre modules de localisation 20 qui sont raccordés le long de la ligne de sécurité 11 en aval de chaque contact de défaut 14. Dans le présent document, on dira par convention qu'un point A est en aval d'un point B sur la ligne de sécurité 11 si le point B est physiquement situé entre le groupe de sécurité 10 et le point A. De même, on dira qu'un point A est en amont d'un point B sur la ligne de sécurité 11 si le point A est physiquement situé entre le groupe de sécurité 10 et le point B.

Selon l'invention, les premiers contacts test 21 servent à localiser des défauts provenant d'un des contacts de défaut de câble 14. Pour cela, lorsqu'un défaut de câble est détecté, c'est-à-dire lorsqu'un des contacts de défaut de câble 14 est ouvert, chaque module de localisation 20 est apte à fermer temporairement et de façon sélective son premier contact test 21 de façon à pouvoir localiser le contact de défaut de câble 14 qui est en défaut le long de la ligne de sécurité 11, selon un fonctionnement qui sera détaillé plus loin.

Par ailleurs, il est également important pour les opérateurs de l'installation de transport de pouvoir aussi localiser les défauts de court-circuit qui peuvent survenir inopinément le long de la ligne de sécurité 11. Quand un défaut de court-circuit survient, par exemple une mise à la terre accidentelle due à une mauvaise connexion électrique sur un des pylônes, la ligne de sécurité 11 n'est plus opérationnelle et il est donc préférable de localiser rapidement ce défaut pour éviter un arrêt prolongé de l'installation de transport.

C'est pourquoi, chaque module de localisation 20 peut aussi comporter avantageusement un contact supplémentaire appelé second contact test 22, ainsi que des moyens électroniques de commande de ce second contact test 22. Le second contact test 22 est un contact normalement fermé et est configuré pour que lorsque l'on commande son ouverture, cela crée une ouverture de la ligne de sécurité 11.

Les seconds contacts test 22 servent à localiser les défauts de court-circuit de la ligne de sécurité 11 car, selon l'invention, lorsqu'une détection de court-circuit apparaît, chaque module de localisation 20 est apte à ouvrir temporairement et de façon sélective son second contact test 22 de façon à pouvoir localiser ledit défaut de court-circuit le long de la ligne de sécurité 11, selon un fonctionnement qui sera détaillé plus loin.

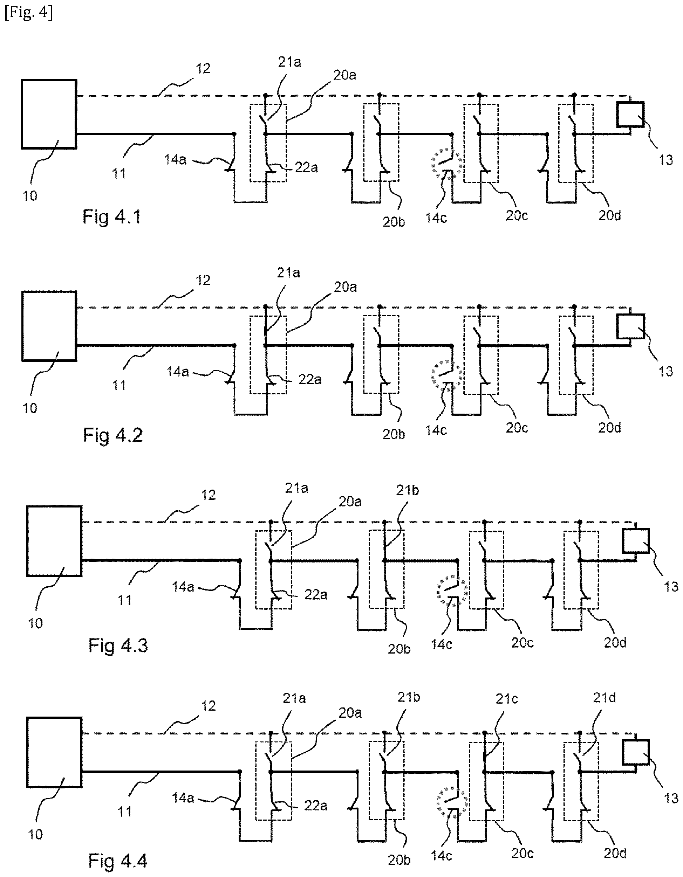

Les figures 4.1 à 4.4 détaillent un mode de réalisation du fonctionnement de la séquence à effectuer pour localiser un défaut de câble. Dans ces figures, on voit quatre modules de localisation 20 appelés respectivement 20a, 20b, 20c, 20d comportant chacun un premier contact test 21, appelés respectivement 21a, 21b, 21c, 21d.

La figure 4.1 montre l'apparition d'un défaut de câble représenté par l'ouverture du contact de défaut de câble 14c ce qui provoque l'ouverture de la ligne de sécurité 11. Suite à la détection de cette ouverture de la ligne de sécurité 11 par le groupe de sécurité 10, une séquence itérative permettant la localisation du défaut de câble démarre. Le groupe de sécurité 10 va en effet demander à des modules de localisation 20 de fermer temporairement un à un (c'est-à-dire séparément l'un après l'autre) leur premier contact test 21 et va analyser les signaux circulant sur la ligne de sécurité 11 après chaque fermeture, jusqu'à déterminer la localisation du défaut de câble entre deux modules de localisation 20 consécutifs.

Le groupe de sécurité 10 sélectionne donc un premier module de localisation 20a (par exemple celui situé le plus près du groupe sécurité 10) et lui demande d'effectuer un court-circuit temporaire (par exemple pendant 1 seconde) en fermant son premier contact test 21a, comme indiqué dans la figure 4.2. A ce moment, si le groupe de sécurité 10 détecte que la ligne de sécurité 11 n'est plus ouverte mais est passée en court-circuit, cela signifie que le contact de défaut de câble 14c qui est ouvert se situe en aval du premier contact test 21a (ce qui est le cas sur la figure 4.2), c'est-à-dire que le premier module de localisation 20a est placé entre le groupe de sécurité 10 et le contact de défaut de câble 14c défaillant.

Ensuite, après avoir attendu que le premier contact test 21a soit réouvert, le groupe de sécurité 10 sélectionne un deuxième module de localisation 20b pour effectuer à son tour un court-circuit temporaire et lui demande de fermer son premier contact test 21b, comme indiqué dans la figure 4.3. A ce moment, si le groupe de sécurité 10 détecte une nouvelle fois que la ligne de sécurité 11 n'est plus ouverte mais est passée en court-circuit, cela signifie que le contact de défaut de câble 14c se situe toujours en aval du premier contact test 21b (ce qui est le cas sur la figure 4.3), c'est-à-dire que le deuxième module de localisation 20b est placé entre le groupe de sécurité 10 et le contact de défaut de câble 14c défaillant.

Ensuite, après avoir attendu que le premier contact test 21b soit réouvert, le groupe de sécurité 10 sélectionne un troisième module de localisation 20c pour effectuer à son tour un court-circuit temporaire en fermant son premier contact test 21c, comme indiqué dans la figure 4.4. Contrairement aux deux cas précédents, le groupe de sécurité 10 ne va alors pas détecter de court-circuit, mais continue de voir la ligne de sécurité 11 ouverte. Cela signifie que le contact de défaut de câble 14c se situe désormais en amont du premier contact test 21c, c'est-à-dire que le contact de défaut de câble 14c défaillant est placé entre le groupe de sécurité 10 et le troisième module de localisation 20c. Il est ainsi facile d'en déduire que le défaut de câble est localisé entre les modules de localisation consécutifs 20b et 20c, ce qui achève la séquence de localisation de défaut de câble.

Dans un système de localisation comportant un nombre N de modules de localisation 20, plusieurs types de séquences itératives sont possibles. Dans l'exemple des figures 4.1 à 4.4, la séquence est dite incrémentale car elle commence par le module de localisation 20a de rang 1 (au plus près du groupe de sécurité 10) puis on incrémente de façon itérative le rang du module de localisation à mettre en court-circuit temporaire, jusqu'à trouver le rang i pour lequel le groupe de sécurité 10 ne détecte plus le court-circuit de la ligne de sécurité 11, pour en déduire que le défaut est localisé entre les modules de localisation 20 de rangs i et i-1.

De façon équivalente, la séquence pourrait être décrémentale, c'est-à-dire commencer par le dernier module de localisation de rang N (au plus près du module d'extrémité 13) puis décrémenter de façon itérative le rang du module de localisation à mettre en court-circuit temporaire, jusqu'à trouver le rang i dans lequel le groupe de sécurité 10 détecte un court-circuit de la ligne de sécurité 11, pour en déduire que le défaut se localise entre les modules de localisation de rangs i et i+1.

De même, la séquence pourrait être dichotomique, c'est-à-dire commencer par mettre en court-circuit temporaire le module de localisation de rang N/2 (ou proche de N/2) pour séparer la ligne de sécurité 11 en deux zones, puis en fonction du résultat, continuer par le module de localisation 20 soit de rang 3N/4, soit de rang N/4 et continuer ainsi en séparant en deux zones à chaque itération jusqu'à arriver à des rangs consécutifs. La séquence dichotomique peut avoir l'avantage d'être plus rapide si le nombre N de modules de localisation est important.

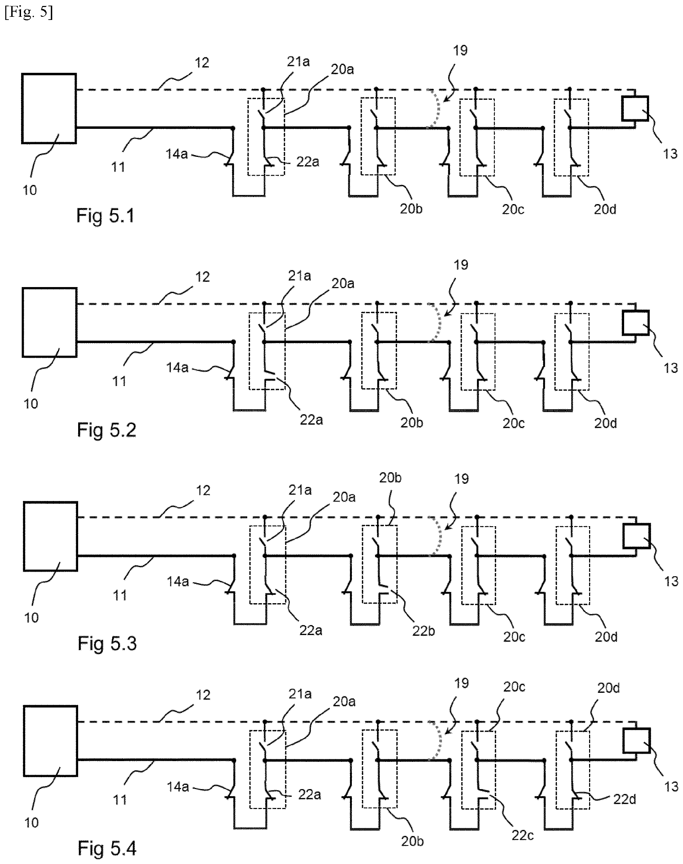

Les figures 5.1 à 5.4 détaillent un mode de réalisation du fonctionnement de la séquence à effectuer pour localiser un défaut de court-circuit. Dans ces figures, on voit quatre modules de localisation 20 appelés respectivement 20a, 20b, 20c, 20d comportant chacun un second contact test 22, appelés respectivement 22a, 22b, 22c, 22d.

La figure 5.1 montre l'apparition d'un défaut de court-circuit entre la ligne de sécurité 11 et la terre survenant à un endroit noté 19. Suite à la détection de ce court-circuit 19 sur la ligne de sécurité 11 par le groupe de sécurité 10, une séquence itérative permettant la localisation du défaut de court-circuit démarre. Le groupe de sécurité 10 va en effet demander à des modules de localisation 20 d'ouvrir un à un (c'est-à-dire séparément l'un après l'autre) leur second contact test 22 et va analyser les signaux circulant sur la ligne de sécurité 11 après chaque ouverture, jusqu'à déterminer la localisation du court-circuit 19 entre deux modules de localisation 20 consécutifs.

Le groupe de sécurité 10 sélectionne donc un premier module de localisation 20a (par exemple celui situé le plus près du groupe sécurité 10) et lui demande d'effectuer une ouverture temporaire de la ligne de sécurité 11 (par exemple pendant 1 seconde) en ouvrant son second contact test 22a, comme indiqué dans la figure 5.2. A ce moment, si le groupe de sécurité 10 détecte que la ligne de sécurité 11 n'est plus en court-circuit mais est ouverte, cela signifie que la localisation du court-circuit 19 est en aval du second contact test 22a (ce qui est le cas sur la figure 5.2), c'est-à-dire que le premier module de localisation 20a est placé entre le groupe de sécurité 10 et le court-circuit 19.

Ensuite, après avoir attendu que le second contact test 22a soit refermé, le groupe de sécurité 10 sélectionne un deuxième module de localisation 20b et lui demande à son tour d'effectuer une ouverture temporaire de la ligne de sécurité 11 en ouvrant son second contact test 22b, comme indiqué dans la figure 5.3. A ce moment, si le groupe de sécurité 10 détecte encore que la ligne de sécurité 11 n'est plus en court-circuit mais est ouverte, cela signifie que la localisation du court-circuit 19 est toujours en aval du second contact test 22b (ce qui est le cas sur la figure 5.3), c'est-à-dire que le deuxième module de localisation 20b est placé entre le groupe de sécurité 10 et le court-circuit 19.

Ensuite, après avoir attendu que le second contact test 22b soit réouvert, le groupe de sécurité 10 sélectionne un troisième module de localisation 20c pour effectuer à son tour ouverture temporaire de la ligne de sécurité 11 et lui demande d'ouvrir son second contact test 22c, comme indiqué dans la figure 5.4. Contrairement aux deux cas précédents, le groupe de sécurité 10 ne va alors pas détecter l'ouverture de ligne de sécurité 11, mais continue de la voir en court-circuit. Cela signifie que le court-circuit 19 se situe désormais en amont du second contact test 22c, c'est-à-dire que le court-circuit 19 est placé entre le groupe de sécurité 10 et le troisième module de localisation 20c. Il est ainsi facile d'en déduire que le court-circuit 19 est localisé entre les modules de localisation consécutifs 20b et 20c, ce qui achève donc la séquence de localisation de défaut de court-circuit.

De la même façon que pour les séquences de localisation de défaut de câble, plusieurs types de séquences sont possibles pour réaliser la localisation d'un court-circuit dans le cadre de l'invention, à savoir une séquence de type incrémental, décrémental, dichotomique ou autre.

Pour renforcer la fiabilité du système, le groupe de sécurité 10 n'émet pas un signal constant sur la ligne de sécurité 11 mais émet un signal variable, comme par exemple un signal carré périodique de tension dont l'amplitude est de l'ordre de +/-12V et dont la période est de l'ordre de quelques dizaines de millisecondes (par exemple 55 millisecondes soit environ 18Hz). Dans ce mode de réalisation, les diagrammes de tension par rapport au temps sont montrés dans la figure 3. Cette figure montre trois courbes de tension S1, S2 et S3 sur la ligne de sécurité 11, en fonction des différentes situations. La première courbe S1 représente le signal mesuré par le groupe de sécurité 10 ou par les modules de localisation 20 lorsque le fonctionnement est normal durant l'émission d'un signal carré. Sur cette courbe S1, l'alternance positive du signal mesuré est en effet atténuée à cause de la diode du module d'extrémité 13 qui est passante vers la terre sur cette alternance.

Lorsqu'un défaut de câble provoque l'ouverture de la ligne de sécurité 11, la deuxième courbe S2 de la figure 3 représente le signal qui est alors mesuré par le groupe de sécurité 10 ou par un module de localisation 20 placé en amont du contact de défaut de câble 14 ouvert. Même si aucun courant ne passe plus dans la ligne de sécurité 11, la courbe S2 correspond alors directement au signal de tension émis par le groupe de sécurité 10, sans atténuation vu que la diode du module d'extrémité 13 n'est plus connectée.

La troisième courbe S3 correspond à un signal nul qui est mesuré en cas de court-circuit de la ligne de sécurité 11. La troisième courbe S3 correspond également au signal qui pourrait être mesuré par un module de localisation 20 situé en aval d'un défaut de câble (c'est-à-dire entre le contact de défaut 14 ouvert et le module d'extrémité 13), car ce module de localisation ne détecte en effet plus rien vu que la ligne de sécurité 11 est ouverte en amont.

Le groupe de sécurité 10 peut communiquer avec les modules de localisation 20 du système de localisation selon un protocole standardisé ou non. Le support physique de cette communication est soit filaire, soit sans fil au moyen par exemple d'un réseau de type WIFI, d'un réseau étendu basse consommation de type LPWAN (Low Power Wide Area Network) ou autres. Si la communication est filaire, elle peut se faire soit directement sur les conducteurs de la ligne de sécurité 11 en superposant les signaux de communication au signal périodique carré, soit préférentiellement en utilisant d'autres conducteurs éventuellement disponibles dans le câble électrique multibrins utilisé pour la ligne de sécurité 11. Pour une installation neuve, on utilisera de préférence une communication filaire à l'aide de conducteurs électriques dédiés. Mais lors de la rénovation d'une installation existante, si aucun autre conducteur n'est disponible, on superposera la communication sur le conducteur de la ligne de sécurité 11.

Cette communication permet notamment au groupe de sécurité 10 de piloter les séquences itératives de localisation en envoyant aux modules de localisation 20 des ordres d'ouverture et fermeture de leur contacts test 21, 22. De plus, afin de renforcer la fiabilité de cette communication, le protocole de communication peut prévoir que durant les séquences itératives, quand le groupe de sécurité 10 envoie à un module de localisation 20 un ordre de fermer son premier contact test 21 ou d'ouvrir son second contact test 22, ce module de localisation 20 renvoie au groupe de sécurité 10 une confirmation par retour de communication pour indiquer que l'ordre a bien été effectué.

Cependant, quand la communication utilise directement le conducteur de la ligne de sécurité 11, il est clair qu'une ouverture ou un court-circuit de cette ligne de sécurité 11 rend la communication impossible entre le groupe de sécurité 10 et tout ou partie des modules de localisation 20. C'est pourquoi, un autre mode de réalisation est proposé dans ce cas, qui ne dépend pas de cette communication.

Dans ce mode de réalisation, les différents modules de localisation 20 peuvent analyser par eux-mêmes les signaux circulant sur la ligne de sécurité 11. Ils possèdent donc des moyens de détection d'un défaut de câble et d'un défaut de court-circuit survenant sur la ligne de sécurité 11 et sont capables de façon sélective de fermer leur premier contact test 21 ou d'ouvrir leur second contact test 22.

Ainsi, lorsqu'une ouverture de la ligne de sécurité 11 est détectée par les modules de localisation 20, la séquence est alors la suivante : le premier module de localisation 20, c'est-à-dire de rang 1, crée un court-circuit en fermant son premier contact test 21 pendant 1 seconde puis en le réouvrant pendant 1 seconde. Le module de localisation 20 de rang 2 attend donc 2 secondes avant de fermer à son tour son premier contact test 21 pendant 2 secondes puis le réouvrir pendant 1 seconde. De même, le module de localisation 20 de rang 3 attend donc 5 secondes avant de fermer son premier contact test 21 pendant 3 secondes puis le réouvrir pendant 1 seconde. Ainsi de suite, chaque module de localisation 20 de rang i attend pendant un temps égal à ((i-1)*(i/2+1)) secondes avant de fermer son premier contact test 21 pendant une durée de i secondes puis le réouvrir pendant 1 seconde. Ainsi, en mesurant le nombre i de secondes pendant lequel un court-circuit temporaire est créé, cela permet de savoir qu'il a été établi par le module de localisation 20 de rang i, sans avoir besoin de communication entre les modules de localisation 20 et le groupe de sécurité 10.

De même, quand un défaut de court-circuit est détecté par les modules de localisation 20, la séquence est la suivante : le premier module de localisation 20 de rang 1, crée une ouverture temporaire de la ligne de sécurité 11 en ouvrant son second contact test 22 pendant 1 seconde puis en le refermant pendant 1 seconde. Le module de localisation 20 de rang 2 attend donc 2 secondes avant d'ouvrir son second contact test 22 pendant 2 secondes puis le refermer pendant 1 seconde. Ainsi de suite, chaque module de localisation 20 de rang i attend pendant un temps égal à ((i-1)*(i/2+1)) secondes avant d'ouvrir son second contact test 22 pendant une durée de i secondes puis le refermer pendant 1 seconde. Ainsi, en mesurant le nombre i de secondes pendant lequel une ouverture temporaire de la ligne de sécurité 11 est créée, cela permet de savoir qu'elle a été établie par le module de localisation 20 de rang i, sans avoir besoin de communication entre modules et groupe de sécurité.

L'alimentation électrique des modules de localisation 20 peut être réalisée de plusieurs façons : ils peuvent être autonomes en énergie s'ils possèdent un accumulateur ou une pile interne, ou bien s'ils sont alimentés par un panneau solaire d'un pylône par exemple. Mais pour éviter d'installer une source d'énergie locale, ils peuvent aussi être alimentés via un conducteur disponible dans le câble électrique multibrins utilisé pour la ligne de sécurité. Enfin, l'alimentation peut venir directement par la ligne de sécurité 11 à partir du signal carré qui est suffisant pour charger une batterie ou une capacité, mais elle peut alors être soumis aux coupures de la ligne de sécurité 11.

L'invention propose également une solution pour mieux appréhender le problème des défauts intempestifs ou fugitifs susceptibles d'apparaître dans une installation de transport par câble, notamment en raison de vibrations sur les galets des pylônes ou de conditions climatiques difficiles (givre, pluie, vent...). Ces défauts aléatoires peuvent aussi bien être des ouvertures fugitives de la ligne de sécurité 11 que des courts-circuits fugitifs. Or, il s'avère que lorsqu'un défaut apparaît seulement de manière fugitive et non pas franche, il est très long et fastidieux d'en trouver l'origine réelle.

Pour cela, il est déjà connu de réaliser une redondance en installant deux lignes de sécurité en parallèle le long de l'installation de transport, avec par exemple un ensemble de paires de barrettes qui sont accolées deux à deux, chaque barrette étant connectée à une des lignes de sécurité. Un premier fonctionnement est alors de travailler dans un mode dit Normal - Secours, c'est-à-dire qu'une seule des deux lignes de sécurité est active à un moment donné et, en cas de panne détectée sur la ligne active, on peut facilement basculer pour activer l'autre ligne de sécurité. Un deuxième fonctionnement est également possible : les deux lignes sont actives pendant le fonctionnement de l'installation de transport. En cas de panne sur l'une des deux lignes, l'opérateur, après avoir fait certains contrôles de sécurité, sélectionne la ligne restée opérationnelle et redémarre l'installation.

Grâce à cette redondance et au système de localisation de l'invention, il est alors plus facile de localiser un défaut sur la ligne de sécurité sujette aux défauts fugitifs lorsqu'elle n'est plus active. Pour mieux cerner un défaut, on cherche alors à raccourcir cette ligne en la tronçonnant en deux parties et à surveiller la partie restante pendant une certaine période suffisante pour voir si le défaut fugitif continue ou non à survenir dans les mêmes conditions.

Pour tronçonner la ligne, le groupe de sécurité 10 demande donc à un module de localisation 20 situé à peu près au milieu la ligne de sécurité d'effectuer une action inverse au défaut détecté : c'est-à-dire soit ouvrir son second contact test 22 si le défaut fugitif est un court-circuit, soit fermer son premier contact test 21 si le défaut fugitif est un défaut de câble. Si le défaut fugitif continue à apparaître dans les mêmes conditions, cela signifie qu'il se situe dans la portion de ligne en amont située entre le groupe de sécurité 10 et le module de localisation 20. Si le défaut fugitif n'apparaît plus dans les mêmes conditions, cela signifie alors qu'il se situe dans la portion de ligne en aval située entre le module de localisation 20 et le module d'extrémité 13. On réitère alors la séquence dichotomique en tronçonnant une nouvelle fois en deux la portion de ligne de sécurité identifiée, jusqu'à localiser le défaut intempestif entre deux modules de localisation consécutifs.

Par ailleurs, des autotests sont réalisables sur le système de localisation pour s'assurer de son bon fonctionnement. Préférentiellement, ces autotests sont réalisés hors fonctionnement de l'installation de transport pour ne pas gêner la sécurité de l'exploitation, par exemple une fois par jour avant le démarrage de l'installation. Le groupe de sécurité demande alors à chaque module de localisation 20 de réaliser successivement une micro-fermeture de leur premier contact test 21 puis une micro-ouverture de leur second contact test 22 et d'analyser les conséquences sur le signal sur la ligne de sécurité 11.

Pour paramétrer et mémoriser le numéro de rang i dans chaque module de localisation 20, on peut par exemple le prédéterminer grâce à un numéro de série ou grâce à des microswitchs sur le module de localisation 20. Préférentiellement, il est cependant préférable de pouvoir paramétrer par logiciel ce numéro de rang i lors d'une phase de configuration en connexion avec un ordinateur, par exemple avant l'installation sur site du module de localisation 20.

Naturellement, l'invention est décrite dans ce qui précède à titre d'exemple. Il est entendu que l'homme du métier est à même de réaliser différentes variantes de réalisation de l'invention sans pour autant sortir du cadre de l'invention telle que définie dans les revendications.

## Revendications

1. Système de localisation de défaut dans une installation de transport par câble,
- le système de localisation comprenant un groupe de sécurité (10), un module d'extrémité (13) et une ligne électrique de sécurité (11) reliant le groupe de sécurité (10) au module d'extrémité (13),
- la ligne de sécurité (11) comprenant une pluralité de contacts de défaut de câble (14), du type normalement fermé, qui sont reliés en série le long de la ligne de sécurité (11) et dont l'ouverture signale un défaut de câble de l'installation de transport, **caractérisé en ce que**:
- le système de localisation comporte une pluralité de modules de localisation (20) répartis le long de l'installation de transport et comprenant chacun un premier contact test (21), du type normalement ouvert, permettant de court-circuiter la ligne de sécurité (11),
- suite à une détection d'un défaut provenant d'un des contacts de défaut de câble (14), chaque module de localisation (20) est apte à fermer de façon sélective son premier contact test (21) de façon à permettre de localiser ledit contact en défaut (14) le long de la ligne de sécurité (11).

2. Système de localisation de défaut selon la revendication 1, **caractérisé en ce que**:
- chaque module de localisation (20) comprend également un second contact test (22), de type normalement fermé, raccordé en série le long de la ligne de sécurité (11),
- suite à une détection d'un défaut de court-circuit sur la ligne de sécurité (11), chaque module de localisation (20) est apte à ouvrir de façon sélective son second contact test (22) de façon à pouvoir localiser ledit défaut de court-circuit le long de la ligne de sécurité (11).

3. Système de localisation de défaut selon la revendication 1 ou 2, **caractérisé en ce que** le groupe de sécurité (10) comprend des moyens de détection d'un défaut de câble et d'un défaut de court-circuit survenant sur la ligne de sécurité (11).

4. Système de localisation de défaut selon la revendication 1, **caractérisé en ce que** le groupe de sécurité (10) comprend des moyens de communication avec les modules de localisation (20) pour demander la fermeture du premier contact test (21) des modules de localisation (20).

5. Système de localisation de défaut selon la revendication 4, **caractérisé en ce que** lors d'une détection d'un défaut de câble provenant d'un des contacts de défaut de câble (14), le groupe de sécurité (10) effectue une séquence itérative en demandant à des modules de localisation (20) de fermer temporairement l'un après l'autre le premier contact test (21), jusqu'à déterminer la localisation du défaut de câble entre deux modules de localisation (20) consécutifs.

6. Système de localisation de défaut selon la revendication 2 **caractérisé en ce que** le groupe de sécurité (10) comprend des moyens de communication avec les modules de localisation (20) pour demander l'ouverture du second contact test (22) des modules de localisation (20).

7. Système de localisation de défaut selon la revendication 6, **caractérisé en ce que** lors d'une détection d'un défaut de court-circuit survenant sur la ligne de sécurité (11), le groupe de sécurité (10) effectue une séquence itérative en demandant à des modules de localisation (20) d'ouvrir temporairement l'un après l'autre leur second contact test (22), jusqu'à déterminer la localisation du défaut de court-circuit entre deux modules de localisation (20) consécutifs.

8. Système de localisation de défaut selon la revendication 2, **caractérisé en ce que** chaque module de localisation (20) comprend des moyens de détection d'un défaut de câble et d'un défaut de court-circuit survenant sur la ligne de sécurité (11).

9. Système de localisation de défaut selon la revendication 8, **caractérisé en ce que** lors d'une détection d'un défaut de câble provenant d'un des contacts de défaut de câble (14), chaque module de localisation (20) ferme son premier contact test (21) pendant une durée prédéterminée qui est fonction du rang du module de localisation (20) dans l'installation de transport.

10. Système de localisation de défaut selon la revendication 8, **caractérisé en ce que** lors d'une détection d'un défaut de court-circuit sur la ligne de sécurité (11), chaque module de localisation (20) ouvre son second contact test (22) pendant une durée prédéterminée qui est fonction du rang du module de localisation (20) dans l'installation de transport.

11. Procédé de localisation de défaut dans une installation de transport par câble à l'aide d'un système de localisation selon la revendication 1, **caractérisé en ce que**, lors d'une détection d'un défaut de câble provenant d'un des contacts de défaut de câble (14), le groupe de sécurité (10) effectue une séquence itérative en demandant à des modules de localisation (20) de fermer temporairement l'un après l'autre leur premier contact test (21) et en analysant les signaux circulant sur la ligne de sécurité (11), jusqu'à déterminer la localisation du défaut de câble entre deux modules de localisation (20) consécutifs.

12. Procédé de localisation de défaut dans une installation de transport par câble à l'aide d'un système de localisation selon la revendication 2, **caractérisé en ce que**, lors d'une détection d'un défaut de court-circuit survenant sur la ligne de sécurité (11), le groupe de sécurité (10) effectue une séquence itérative en demandant à des modules de localisation (20) d'ouvrir temporairement l'un après l'autre leur second contact test (22) et en analysant les signaux circulant sur la ligne de sécurité (11), jusqu'à déterminer la localisation du défaut de court-circuit entre deux modules de localisation (20) consécutifs.

13. Procédé de localisation de défaut selon la revendication 11 ou 12, **caractérisé en ce que** la séquence itérative est de type incrémental, décrémental ou dichotomique.

## Patentansprüche

1. System zum Lokalisieren von Fehlern in einer Seilförderanlage,
- das Lokalisierungssystem umfassend eine Sicherheitsgruppe (10), ein Endmodul (13) und eine elektrische Sicherheitsleitung (11), die die Sicherheitsgruppe (10) mit dem Endmodul (13) verbindet,
- die Sicherheitsleitung (11) umfassend eine Vielzahl von Seilfehlerkontakten (14) von der normalerweise geschlossenen Art, die entlang der Sicherheitsleitung (11) in Reihe geschaltet sind und deren Öffnung einen Seilfehler der Förderanlage signalisiert, **dadurch gekennzeichnet, dass:**
- das Lokalisierungssystem eine Vielzahl von Lokalisierungsmodulen (20) aufweist, die entlang der Förderanlage verteilt sind und jeweils umfassend einen ersten Prüfkontakt (21) von der normalerweise offenen Art, der es ermöglicht, die Sicherheitsleitung (11) kurzuschließen,
- im Anschluss an ein Erfassen eines Fehlers von einem der Seilfehlerkontakte (14), jedes Lokalisierungsmodul (20) geeignet ist, um auf selektive Weise seinen ersten Prüfkontakt (21) zu schließen, um zu ermöglichen, dass der fehlerhafte Kontakt (14) entlang der Sicherheitsleitung (11) lokalisiert wird.

2. Fehlerlokalisierungssystem nach Anspruch 1,
**dadurch gekennzeichnet, dass:**
- jedes Lokalisierungsmodul (20) auch einen zweiten Prüfkontakt (22) der normalerweise geschlossenen Art umfasst, der entlang der Sicherheitsleitung (11) in Reihe angeschlossen ist,
- im Anschluss an ein Erfassen eines Kurzschlussfehlers an der Sicherheitsleitung (11), jedes Lokalisierungsmodul (20) geeignet ist, um auf selektive Weise seinen zweiten Prüfkontakt (22) zu öffnen, um den Kurzschlussfehler entlang der Sicherheitsleitung (11) lokalisieren zu können.

3. Fehlerlokalisierungssystem nach Anspruch 1 oder 2,
**dadurch gekennzeichnet, dass** die Sicherheitsgruppe (10) Mittel zum Erfassen eines Seilfehlers und eines Kurzschlussfehlers umfasst, der in der Sicherheitsleitung (11) plötzlich auftritt.

4. Fehlerlokalisierungssystem nach Anspruch 1,
**dadurch gekennzeichnet, dass** die Sicherheitsgruppe (10) Mittel zum Kommunizieren mit den Lokalisierungsmodulen (20) zum Anfordern des Schließens des ersten Prüfkontakts (21) der Lokalisierungsmodule (20) umfasst.

5. Fehlerlokalisierungssystem nach Anspruch 4,
**dadurch gekennzeichnet, dass** während einer Erfassung eines Seilfehlers von einem der Seilfehlerkontakte (14) die Sicherheitsgruppe (10) eine iterative Sequenz vornimmt, indem von den Lokalisierungsmodulen (20) angefordert wird, jeweils nacheinander den ersten Prüfkontakt (21) vorübergehend zu schließen, bis die Lokalisierung des Seilfehlers zwischen zwei aufeinanderfolgenden Lokalisierungsmodulen (20) bestimmt wird.

6. Fehlerlokalisierungssystem nach Anspruch 2
**dadurch gekennzeichnet, dass** die Sicherheitsgruppe (10) Mittel zum Kommunizieren mit den Lokalisierungsmodulen (20) zum Anfordern des Öffnens des zweiten Prüfkontakts (22) der Lokalisierungsmodule (20) umfasst.

7. Fehlerlokalisierungssystem nach Anspruch 6,
**dadurch gekennzeichnet, dass** bei einer Erfassung eines Kurzschlussfehlers, der in der Sicherheitsleitung (11) plötzlich auftritt, die Sicherheitsgruppe (10) eine iterative Sequenz vornimmt, indem von den Lokalisierungsmodulen (20) angefordert wird, nacheinander ihren zweiten Prüfkontakt (22) vorübergehend zu öffnen, bis die Lokalisierung des Kurzschlussfehlers zwischen aufeinanderfolgenden Lokalisierungsmodulen (20) bestimmt wird.

8. Fehlerlokalisierungssystem nach Anspruch 2,
**dadurch gekennzeichnet, dass** jedes Lokalisierungsmodul (20) Mittel zum Erfassen eines Seilfehlers und eines Kurzschlussfehlers, der plötzlich in der Sicherheitsleitung (11) auftritt, umfasst.

9. Fehlerlokalisierungssystem nach Anspruch 8,
**dadurch gekennzeichnet, dass** während einer Erfassung eines Seilfehlers von einem der Seilfehlerkontakte (14) jedes Lokalisierungsmodul (20) seinen ersten Prüfkontakt (21) für eine vorbestimmte Zeitdauer schließt, die von dem Rang des Lokalisierungsmoduls (20) in der Förderanlage abhängig ist.

10. Fehlerlokalisierungssystem nach Anspruch 8,
**dadurch gekennzeichnet, dass** während einer Erfassung eines Kurzschlussfehlers an der Sicherheitsleitung (11) jedes Lokalisierungsmodul (20) seinen zweiten Prüfkontakt (22) für eine vorbestimmte Zeitdauer öffnet, die von dem Rang des Lokalisierungsmoduls (20) in der Förderanlage abhängig ist.

11. Verfahren zum Lokalisieren von Fehlern in einer Seilförderanlage unter Verwendung eines Lokalisierungssystems nach Anspruch 1,
**dadurch gekennzeichnet, dass** bei einer Erfassung eines Seilfehlers von einem der Seilfehlerkontakte (14) die Sicherheitsgruppe (10) eine iterative Sequenz vornimmt, indem von den Lokalisierungsmodulen (20) angefordert wird, nacheinander ihren ersten Prüfkontakt (21) vorübergehend zu schließen, und indem die Signale analysiert werden, die auf der Sicherheitsleitung (11) zirkulieren, bis die Lokalisierung des Seilfehlers zwischen aufeinanderfolgenden Lokalisierungsmodulen (20) bestimmt wird.

12. Verfahren zum Lokalisieren von Fehlern in einer Seilförderanlage unter Verwendung eines Lokalisierungssystems nach Anspruch 2,
**dadurch gekennzeichnet, dass** bei einer Erfassung eines Kurzschlussfehlers, der in der Sicherheitsleitung (11) plötzlich auftritt, die Sicherheitsgruppe (10) eine iterative Sequenz vornimmt, indem von den Lokalisierungsmodulen (20) angefordert wird, nacheinander ihren zweiten Prüfkontakt (22) vorübergehend zu öffnen, und indem die Signale analysiert werden, die auf der Sicherheitsleitung (11) zirkulieren, bis die Lokalisierung des Kurzschlussfehlers zwischen aufeinanderfolgenden Lokalisierungsmodulen (20) bestimmt wird.

13. Fehlerlokalisierungsverfahren nach Anspruch 11 oder 12,
**dadurch gekennzeichnet, dass** die iterative Sequenz von einer inkrementellen, dekrementellen oder dichotomischen Art ist.

## Claims

1. A fault location system in a cable transport installation,
- the location system comprising a safety unit (10), an end module (13), and an electrical safety line (11) connecting the safety unit (10) to the end module (13),
- the safety line (11) comprising a plurality of cable fault contacts (14), of the normally closed type, which are connected in series along the safety line (11) and which, when opened, signal a cable fault in the transport installation, **characterized in that**:
- the location system includes a plurality of location modules (20) distributed along the transport installation, each comprising a first test contact (21), of the normally open type, for short-circuiting the safety line (11),
- once a fault coming from one of the cable fault contacts (14) is detected, each location module (20) is capable of selectively closing its first test contact (21) so as to make it possible to locate said faulty contact (14) along the safety line (11).

2. The fault location system according to claim 1, **characterized in that**:
- each location module (20) also comprises a second test contact (22), of the normally closed type, connected in series along the safety line (11),
- once a short-circuit fault is detected on the safety line (11), each location module (20) is capable of selectively opening its second test contact (22) so that said short-circuit fault can be located along the safety line (11).

3. The fault location system according to claim 1 or 2, **characterized in that** the safety unit (10) comprises means for detecting a cable fault and a short-circuit fault occurring on the safety line (11).

4. The fault location system according to claim 1, **characterized in that** the safety unit (10) comprises means for communicating with the location modules (20) in order to request that the first test contact (21) of the location modules (20) be closed.

5. The fault location system according to claim 4, **characterized in that**, when a cable fault coming from one of the cable fault contacts (14) is detected, the safety unit (10) carries out an iterative sequence by asking location modules (20) to temporarily close the first test contact (21), one after the other, until the location of the cable fault between two consecutive location modules (20) is determined.

6. The fault location system according to claim 2, **characterized in that** the safety unit (10) comprises means for communicating with the location modules (20) in order to request that the second test contact (22) of the location modules (20) be opened.

7. The fault location system according to claim 6, **characterized in that**, when a short-circuit fault occurring on the safety line (11) is detected, the safety unit (10) carries out an iterative sequence by asking location modules (20) to temporarily open their second test contact (22), one after the other, until the location of the short-circuit fault between two consecutive location modules (20) is determined.

8. The fault location system according to claim 2, **characterized in that** each location module (20) comprises means for detecting a cable fault and a short-circuit fault occurring on the safety line (11).

9. The fault location system according to claim 8, **characterized in that**, when a cable fault coming from one of the cable fault contacts (14) is detected, each location module (20) closes its first test contact (21) for a predetermined time that is a function of the ranking of the location module (20) in the transport installation.

10. The fault location system according to claim 8, **characterized in that**, when a short-circuit fault is detected on the safety line (11), each location module (20) opens its second test contact (22) for a predetermined time that is a function of the ranking of the location module (20) in the transport installation.

11. A method for locating a fault in a cable transport installation using a location system according to claim 1, **characterized in that**, when a cable fault coming from one of the cable fault contacts (14) is detected, the safety unit (10) carries out an iterative sequence by asking location modules (20) to temporarily close their first test contact (21), one after the other, and by analyzing the signals traveling over the safety line (11), until the location of the cable fault between two consecutive location modules (20) is determined.

12. The method for locating a fault in a cable transport installation using a location system according to claim 2, **characterized in that**, when a short-circuit fault occurring on the safety line (11) is detected, the safety unit (10) carries out an iterative sequence by asking location modules (20) to temporarily open their second test contact (22), one after the other, and by analyzing the signals traveling over the safety line (11), until the location of the short-circuit fault between two consecutive location modules (20) is determined.

13. The method for locating a fault according to claim 11 or 12, **characterized in that** the iterative sequence is incremental, decremental, or dichotomous.
